# EUROPEAN PATENT APPLICATION

(11) **EP 2 280 433 A1**
(43) Date of publication of application: **02.02.2011**
(21) Application number: 09738729.4
(22) Date of filing: 15.04.2009
(51) Int. Cl.: H01L 51/42

(54) **ORGANIC PHOTOELECTRIC CONVERSION ELEMENT AND MANUFACTURING METHOD THEREOF**

(30) Priority: 28.04.2008 JP 2008116950; 25.07.2008 JP 2008191893; 23.01.2009 JP 2009012868
(71) Applicant: Sumitomo Chemical Company, Limited, Tokyo 104-8260 (JP)
(72) Inventor: UETANI, Yasunori, Tsukuba-shi Ibaraki 305-0045 (JP)
(74) Representative: Vossius & Partner
(86) International application number: PCT/JP2009/057948
(87) International publication number: WO 2009/133792

(57) **Abstract**

An organic photoelectric conversion element comprising a plurality of active layers and a junction positioned between the active layers which are laminated between a pair of electrodes, wherein the junction is formed from a plurality of layers including a positive hole transport layer, and the positive hole transport layer is formed first by a coating method when the junction is formed.

## Description

### Technical Field

The present invention relates to an organic photoelectric conversion element and a method for manufacturing the same.

### Background Art

Recently, much attention is being paid to an organic photoelectric conversion element utilizing light energy (organic solar cells, light sensors, and the like). Since a high electromotive force can be obtained upon laminating a plurality of cells, an element having a multi-junction structure represented by a tandem structure, on which two or more cells are laminated, is expected to be useful. In the organic photoelectric conversion element having a multi-junction structure, the cells are not merely laminated, but a suitable junction is provided between the cells.

The junction is usually formed by laminating a plurality of layers such as an electron transport layer, a charge recombination layer and a positive hole transport layer. An example is known in which PEDOT/PSS {poly(3,4-ethylenedioxythiophene) (PEDOT) and poly(4-styrenesulfonic acid) (PSS)} is used for the positive hole transport layer constituting the junction. The positive hole transport layer is formed by a coating method using a coating solution containing the PEDOT/PSS after formation of the electron transport layer and the charge recombination layer (for example, Advanced Functional Materials, 2006, Vol. 16, p. 1897-1903, Science, 2007, Vol. 317, p. 222-225).

### Disclosure of the Invention

If the positive hole transport layer is formed by a coating method, it is feared that the electron transport layer and the charge recombination layer in the junction, which are formed prior to the positive hole transport layer, are damaged, for example, by being dissolved in water contained in a coating solution.

An object of the present invention is to provide an organic photoelectric conversion element provided with a j unction which is suppressed in damage upon film formation, and a method for manufacturing the same.

The present invention provides an organic photoelectric conversion element comprising a plurality of active layers and a junction positioned between the active layers which are laminated between a pair of electrodes, wherein the junction is formed from a plurality of layers including a positive hole transport layer, and the positive hole transport layer is formed first by a coating method when the junction is formed.

The present invention also provides an organic photoelectric conversion element wherein the positive hole transport layer is formed using a coating solution having a pH of 5 to 9.

The present invention further provides a photoelectric conversion element wherein the junction includes an electron transport layer formed by a coating method using a dispersion liquid prepared by dispersing particles of titanium dioxide in a dispersion medium.

The present invention further provides an organic photoelectric conversion element wherein the active layers contain a conjugated polymer compound and a fullerene derivative.

The present invention further provides a method for manufacturing an organic photoelectric conversion element by laminating a pair of electrodes and a plurality of active layers and a junction positioned between the active layers, between the pair of electrodes, the method including: forming a positive hole transport layer first by a coating method when the junction formed from a plurality of layers including the positive hole transport layer is formed.

### Mode for Carrying Out the Invention

The present invention will be described in detail below.

### <Organic photoelectric conversion element>

The organic photoelectric conversion element in the present embodiment is characterized in that at least a plurality of active layers and a junction positioned between the active layers are laminated between a pair of electrodes; the junction is formed from a plurality of layers including a positive hole transport layer; and the positive hole transport layer among a plurality of layers constituting the junction is formed first by a coating method. Namely, the positive hole transport layer is formed first by a coating method in the formation of the junction.

The organic photoelectric conversion element in the present embodiment has a so-called multi-junction structure. Examples of element structures of the organic photoelectric conversion element are shown below.
(a) anode/active layer/junction/active layer/cathode
(b) anode/(repeating unit)n/active layer/cathode

(Symbol "/" represents that the layers of both sides of the symbol "/" are laminated adjacently. The same shall apply hereinafter.) In structure (b), the "(repeating unit)" represents a laminate consisting of an active layer and a junction (active layer/junction), symbol "n" represents an integer of not less than 2, and the "(repeating unit)n" represents a laminate in which n laminated bodies (active layer/junction) are laminated. In this connection, an electron transport layer may be provided between the anode and the active layer, and a positive hole transport layer may be provided between the active layer and the cathode.

Structure (a) represents an element having a so-called tandem structure (the tandem structure refers to a multi-junction structure in which two cells are laminated), and structure (b) represents an element having a multi-junction structure in which (n + 1) cells are laminated.

The junction is formed by laminating a plurality of layers, and includes at least a positive hole transport layer. The junction is formed, for example, by laminating a positive hole transport layer, a charge recombination layer, and an electron transport layer in this order.

The junction may be formed only of the positive hole transport layer and the electron transport layer, or it may have layers other than the above-described three types of layers. In the junction including the positive hole transport layer and the electron transport layer, the positive hole transport layer is positioned on an anode side, and the electron transport layer is positioned on a cathode side.

For example, the active layer may be a laminate in which a first layer containing an electron-accepting compound and a second layer containing an electron-donating compound are laminated adjacently, or may be a single layer containing the electron-accepting compound and the electron-donating compound.

Next, the actuating mechanism of the organic photoelectric conversion element will be explained. The light energy incident from a transparent or translucent electrode is absorbed by an electron-accepting compound and/or an electron-donating compound to generate an exciton consisting of a bound electron-positive hole. When the generated exciton moves and reaches a heterojunction interface where the electron-accepting compound and the electron-donating compound are present adjacently, the electron and the positive hole separate due to the difference of their HOMO energy and LUMO energy in the interface to generate charges (electron and positive hole) capable of moving separately. The generated charges can move to respective electrodes and can be taken outside as electric energy (current).

Usually, the organic photoelectric conversion element is formed by laminating a pair of electrodes, active layers, and junctions on a substrate sequentially in the order described below.

For example, an element having the above-described structure (a) can be formed by laminating an anode, an active layer, a junction, an active layer, and a cathode on a substrate sequentially in this order. An element having the above-described structure (b) can be also formed in the same manner as in an element having the above-described structure (a), by laminating an anode, an active layer, a junction, an active layer, a junction, ......, an active layer, and a cathode on a substrate sequentially in this order.

A method for manufacturing the organic photoelectric conversion element of the present invention is characterized in that, in the step of forming a junction, the positive hole transport layer of a plurality of layers constituting the junction is formed first by a coating method. The substrate may be any material which forms an electrode and does not alter when layers of organic materials are formed. Examples of the material for the substrate include glass, plastic, polymer films, silicon, and the like. In the case of an opaque substrate, an opposite electrode (i.e. an electrode distal from the substrate) is preferably transparent or translucent. Constituents of the organic photoelectric conversion element and methods for manufacturing the same will be described below.

### (Positive hole transport layer)

Among a plurality of layers constituting the junction, the positive hole transport layer in the present embodiment is formed first by a coating method. Conventionally, the positive hole transport layer was formed by a coating method after formation of an electron transport layer and a charge recombination layer, and therefore, it was feared that the electron transport layer and the charge recombination layer previously formed are damaged when the positive hole transport layer is formed. By forming the positive hole transport layer first, however, layers in the junction except the positive hole transport layer are basically not damaged when forming the positive hole transport layer. Accordingly, it is possible to realize an organic photoelectric conversion element having reduced damage of the junction, and eventually, an organic photoelectric conversion element having high photoelectric conversion efficiency.

The positive hole transport layer consists preferably of a polymer compound, and more preferably of a highly electrically conductive polymer compound. The electrical conductivity of a highly electrically conductive polymer compound is usually from 10⁻⁵ to 10⁵ S/cm, and preferably from 10⁻³ to 10⁴ S/cm. By providing the positive hole transport layer consisting of a highly electrically conductive polymer compound in contact with a charge recombination layer and an active layer, it is possible to enhance not only tight adhesion with the charge recombination layer and the active layer, but also positive hole-injection efficiency from the active layer to the charge recombination layer.

The positive hole transport layer is a layer capable of exerting functions shown below. The functions of the positive hole transport layer include a function to enhance an injection efficiency of a positive hole into a charge recombination layer, a function to prevent injection of an electron from an active layer, a function to enhance a transport ability of a positive hole, a function to enhance flatness of a charge recombination layer in the case of preparing the charge recombination layer by a vapor deposition method, a function to protect an active layer from erosion by a coating solution for forming a charge recombination layer in the case of preparing the charge recombination layer by a coating method, a function to suppress deterioration of an active layer, and the like.

As a material constituting the positive hole transport layer, polymer compounds exhibiting a function to transport a positive hole can be used, and examples thereof include polymer compounds having a thiophenediyl group, polymer compounds having an anilinediyl group, polymer compounds having a pyrrolediyl group, and the like.

These polymer compounds may have an acid group such as a sulfonic acid group, and examples thereof include poly(thiophene) and poly(aniline) having an acid group such as a sulfonic acid group as a substituent. These poly (thiophene) and poly(aniline) may have other substituents, and examples thereof include a halogen atom, an alkyl group having 1 to 20 carbon atoms, an alkoxy group having 1 to 20 carbon atoms, an aryl group having 6 to 60 carbon atoms, and a group represented by formula (5): 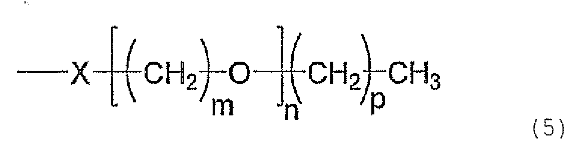 wherein n represents an integer of 1 to 4, m represents an integer of 1 to 6, p represents an integer of 0 to 5, and X represents an oxygen atom or a direct bond. From the viewpoint of solubility in water and an alcoholic solvent, the above-described compounds preferably have an alkoxy group or a group represented by formula (5).

In the present invention, the coating solution and the solution also include a dispersion system such as an emulsion and a suspension.

The material constituting the positive hole transport layer may contain, in addition to the above-described polymer compounds, other polymer compounds as a binder. Examples of the binder include polystyrene sulfonic acid, polyvinyl phenol, a novolak resin, polyvinyl alcohol, and the like.

The coating solution used when the positive hole transport layer is formed by a coating method contains a material for a positive hole transport layer and a solvent. From the viewpoint of enhancing an electromotive force of the organic photoelectric conversion element, the pH of the coating solution is preferably from 5 to 9, and more preferably from 6 to 8. Solvents for the coating solution include water, alcohols, and the like. Specific examples of the alcohols include methanol, ethanol, isopropanol, butanol, ethylene glycol, propylene glycol, butoxyethanol and methoxybutanol. It is also possible to use a mixed solution containing two or more solvents described above, for example, as a solvent for the coating solution.

In the present specification, the pH is a value measured using a pH test paper.

For the film formation of the coating solution, coating methods such as a spin coating method, a casting method, a microgravure coating method, a gravure coating method, a bar coating method, a roll coating method, a wire bar coating method, a dip coating method, a spray coating method, a screen printing method, a flexographic printing method, an offset printing method, an ink jet printing method, a dispenser printing method, a nozzle coating method, and a capillary coating method can be used. Among these coating methods, a spin coating method, a flexographic printing method, an ink jet printing method, and a dispenser printing method are preferably used.

### (Charge recombination layer)

Although it is not necessarily required to provide the charge recombination layer, the layer is preferably provided between an electron transport layer and a positive hole transport layer for ohmic junction of the electron transport layer and the positive hole transport layer. The charge recombination layer is preferably formed in a state where fine particles are aggregated, or a thin film state so that light easily transmits the layer.

Usually, the charge recombination layer contains a metal. The charge recombination layer may contain a metal oxide and a metal halide, and the total of the weight of the metal oxide and the weight of the metal halide is preferably 10 or less, when the weight of the metal is regarded as 100. More preferably, the layer consists essentially of a metal. Examples of the metal include lithium, beryllium, sodium, magnesium, aluminum, potassium, calcium, scandium, titanium, vanadium, chromium, manganese, iron, cobalt, nickel, copper, zinc, gallium, germanium, rubidium, strontium, yttrium, zirconium, niobium, molybdenum, ruthenium, rhodium, palladium, silver, cadmium, indium, tin, antimony, cesium, barium, lanthanum, hafnium, tantalum, tungsten, rhenium, osmium, iridium, platinum, gold, mercury, thallium, lead, bismuth, and lanthanides. It is also possible to use, for example, an alloy of these metals, graphite or an intercalation compound of these metals with graphite for the charge recombination layer. Among the above-described metals, aluminum, magnesium, titanium, chromium, iron, nickel, copper, zinc, gallium, zirconium, molybdenum, silver, indium, tin, and gold are preferred.

Methods for forming the charge recombination layer are not limited to a particular one, and include a vacuum vapor deposition method from powder.

### (Electron transport layer)

The electron transport layer contains a halide or an oxide of an alkali metal or an alkaline earth metal such as lithium fluoride, an electron-accepting compound described later, or the like. Further, the electron transport layer may be constituted using particles consisting of an inorganic semiconductor such as titanium oxide.

The functions of the electron transport layer include a function to enhance an injection efficiency of an electron into a charge recombination layer, a function to prevent injection of a positive hole from an active layer, a function to enhance a transport ability of an electron, a function to suppress deterioration of an active layer, and the like.

Methods for forming the electron transport layer are not limited to a particular one, and include a vacuum vapor deposition method from powder, and a method by film formation from a solution or a molten state in the case of a low-molecular electron transport material, and include a method by film formation from a solution or a molten state in the case of a polymer electron transport material. In film formation from a solution or a molten state, a polymer binder may be used concomitantly. Methods for forming the electron transport layer from a solution include the same film formation method as the above-described method for forming the positive hole transport layer from a solution.

If the electron transport layer is formed by a coating method using particles consisting of an inorganic semiconductor such as titanium oxide, the layer is formed by applying a dispersion liquid in which the inorganic semiconductor is dispersed in a dispersion medium to a given layer. The dispersion liquid contains a dispersion medium and an inorganic semiconductor, and the inorganic semiconductor is preferably fine particles, and preferably titanium dioxide. The particle size of the inorganic semiconductor is preferably 10 µm or less, and more preferably 1 µm or less. From the viewpoint of enhancing photoelectric conversion efficiency of the photoelectric conversion element, the particle size is preferably 100 nm or less, and more preferably 50 nm or less. From the viewpoint of enhancing dispersibility of the inorganic semiconductor in a dispersion medium, the particle size is preferably 30 nm or less. Further, it is preferable to add a dispersant to the dispersion liquid so as to enhance dispersibility of the inorganic semiconductor in a dispersion medium. Examples of the dispersant include acetic acid, hydrochloric acid, nitric acid and sulfuric acid. Acetic acid is preferable from the viewpoint of easy handling of the dispersion liquid, corrosion prevention of the electrode, and the like. In this connection, the description "the particle size of the inorganic semiconductor is 10 µm or less" in the present invention means that the particle sizes of substantially all the inorganic semiconductor particles contained in a dispersion liquid are 10 µm or less.

Examples of the dispersion medium contained in a dispersion liquid include water and alcohols. Examples of the alcohols include methanol, ethanol, isopropanol, butanol, ethylene glycol, propylene glycol, butoxyethanol and methoxybutanol.

The dispersion liquid used in the present invention may contain two or more solvents described above.

The electrical conductance of the inorganic semiconductor is preferably 0.01 mS/cm or more, and more preferably 1 mS/cm or more. The electrical conductance is preferably 10 mS/cm or more from the viewpoint of enhancing the photoelectric conversion efficiency.

If the junction consists of a positive hole transport layer, a charge recombination layer and an electron transport layer, the electron transport layer is formed by applying the above-described dispersion medium to the charge recombination layer, and then removing the dispersion medium. Moreover, if the electron transport layer is formed on an anode, the electron transport layer is formed by applying the above-described dispersion medium to the anode, and then removing the dispersion medium. Removal of the dispersion medium is carried out, for example, by leaving the junction for a given period in the atmosphere, and heating the junction if necessary.

As a method for applying the dispersion liquid to a given layer, coating methods such as a spin coating method, a casting method, a microgravure coating method, a gravure coating method, a bar coating method, a roll coating method, a wire bar coating method, a dip coating method, a spray coating method, a screen printing method, a flexographic printing method, an offset printing method, an ink jet printing method, a dispenser printing method, a nozzle coating method, and a capillary coating method can be used. Among these coating methods, a spin coating method, a flexographic printing method, an ink jet printing method and a dispenser printing method are preferably used. The electron transport layer preferably has a film thickness within a range from 1 nm to 100 µm, more preferably from 2 nm to 1,000 nm, still more preferably from 5 nm to 500 nm, and further preferably from 20 nm to 200 nm.

### (Active layer)

The active layer preferably contains a polymer compound. The active layer may contain a single polymer compound, or two or more polymer compounds. It is also possible to use a mixture of an electron-donating compound and/or an electron-accepting compound in the active layer in order to enhance a charge transport ability of the active layer. The electron-accepting compound is preferably a fullerene derivative from the viewpoint that it contains many heterojunction interfaces. In particular, it is preferable that a conjugated polymer compound and a fullerene derivative are contained in the active layer. For example, it is possible to use an organic thin film containing a conjugated polymer compound and a fullerene derivative as an active layer. The proportion of the fullerene derivative in the active layer containing the fullerene derivative and an electron-donating compound is preferably from 10 to 1, 000 parts by weight, and more preferably 50 to 500 parts by weight, based on 100 parts by weight of the electron-donating compound.

The electron-accepting compound used suitably for the organic photoelectric conversion element is one in which the HOMO energy of the electron-accepting compound is higher than the HOMO energy of an electron-donating compound, and the LUMO energy of the electron-accepting compound is higher than the LUMO energy of the electron-donating compound.

The electron-donating compound contained in the active layer may be a low-molecular compound or a polymer compound. Examples of the low-molecular compound include phthalocyanine, metallophthalocyanine, porphyrin, metalloporphyrin, oligothiophene, tetracene, pentacene and rubrene. Examples of the polymer compound include polyvinyl carbazole and derivatives thereof, polysilane and derivatives thereof, polysiloxane derivatives having an aromatic amine in a side chain or a main chain, polyaniline and derivatives thereof, polythiophene and derivatives thereof, polypyrrole and derivatives thereof, polyphenylene vinylene and derivatives thereof, polythienylene vinylene and derivatives thereof, and polyfluorene and derivatives thereof.

The electron-accepting compound contained in the active layer may be a low-molecular compound or a polymer compound. Examples of the low-molecular compound include oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, metal complexes of 8-hydroxyquinoline and derivatives thereof, polyquinoline and derivatives thereof, polyquinoxaline and derivatives thereof, polyfluorene and derivatives thereof, fullerenes such as C₆₀ fullerene and derivatives thereof, and phenanthrene derivatives such as bathocuproine. Examples of the polymer compound include polyvinyl carbazole and derivatives thereof, polysilane and derivatives thereof, polysiloxane derivatives having an aromatic amine in a side chain or a main chain, polyaniline and derivatives thereof, polythiophene and derivatives thereof, polypyrrole and derivatives thereof, polyphenylene vinylene and derivatives thereof, polythienylene vinylene and derivatives thereof, and polyfluorene and derivatives thereof. Preferred among them are fullerenes and derivatives thereof.

The fullerenes include C₆₀ fullerene, C₇₀ fullerene, carbon nanotube fullerene, and derivatives thereof. The following compounds are mentioned as examples of C₆₀ fullerene derivatives.

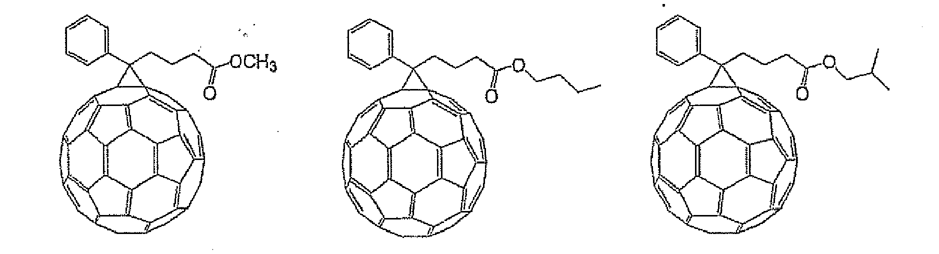

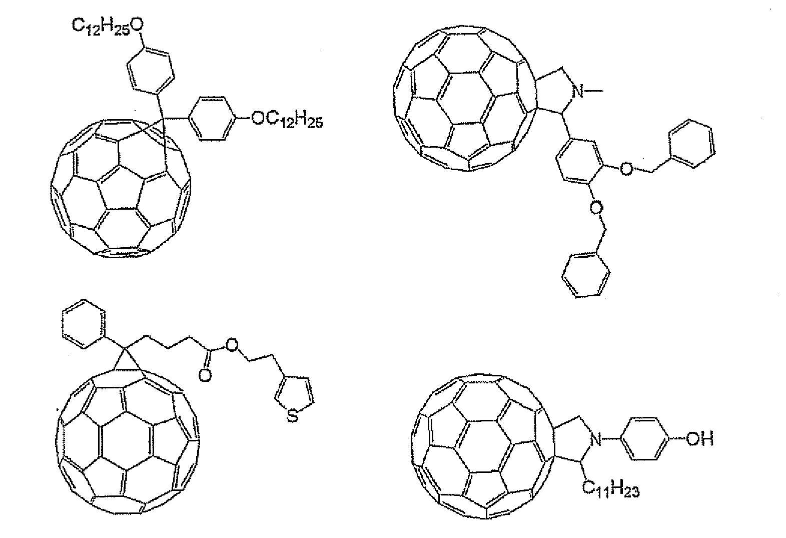

The active layer usually has a film thickness within a range from 1 nm to 100 µm, preferably from 2 nm to 1,000 nm, more preferably from 5 nm to 500 nm, and still more preferably from 20 nm to 200 nm.

Methods for forming the active layer include, for example, a method by film formation from a composition containing a solvent, a conjugated polymer compound and a fullerene derivative. Examples of the solvent include unsaturated hydrocarbon solvents such as toluene, xylene, mesitylene, tetralin, decalin, bicyclohexyl, n-butylbenzene, sec-butylbenzene, and tert-butylbenzene, halogenated saturated hydrocarbon solvents such as carbon tetrachloride, chloroform, dichloromethane, dichloroethane, chlorobutane, bromobutane, chloropentane, bromopentane, chlorohexane, bromohexane, chlorocyclohexane, and bromocyclohexane, halogenated unsaturated hydrocarbon solvents such as chlorobenzene, dichlorobenzene, and trichlorobenzene, and ether solvents such as tetrahydrofuran and tetrahydropyran. For film formation, a method described as the method for forming the positive hole transport layer can be used.

Examples of the above-described conjugated polymer compound include polymer compounds which contain, as a repeating unit, one or more groups selected from the group consisting of an unsubstituted or substituted fluorenediyl group, an unsubstituted or substituted benzofluorenediyl group, a dibenzofurandiyl group, an unsubstituted or substituted dibenzothiophenediyl group, an unsubstituted or substituted carbazolediyl group, an unsubstituted or substituted thiophenediyl group, an unsubstituted or substituted furandiyl group, an unsubstituted or substituted pyrrolediyl group, an unsubstituted or substituted benzothiadiazolediyl group, an unsubstituted or substituted phenylenevinylenediyl group, an unsubstituted or substituted thienylenevinylenediyl group, and an unsubstituted or substituted triphenylaminediyl group, the repeating unit being bound to another repeating unit directly or via a linking group.

If the above-described repeating unit is bound to another repeating unit via a linking group in the above-described conjugated polymer compound, examples of the linking group include phenylene, biphenylene, naphthalenediyl, and anthracenediyl.

Preferable examples of the conjugated polymer compound include, for example, polymer compounds which contain one or more repeating units selected from the group consisting of a thiophenediyl group and polymer compounds having a fluorenediyl group, the repeating unit being bound to another repeating unit directly or via a linking group.

### (Electrode)

Examples of transparent or translucent electrode materials include an electrically conductive metal oxide film and an electrically conductive translucent metal thin film. Specifically, indium oxide, zinc oxide, tin oxide, indium tin oxide (abbreviation: ITO), indium zinc oxide (abbreviation: IZO) as well as gold, platinum, silver, copper, and the like are used, and ITO, IZO, and tin oxide are preferred. Further, an organic, transparent, electrically conductive film, which is made of polyaniline or a derivative thereof, polythiophene or a derivative thereof, or the like, may be used as an electrode.

It is also possible to use a metal thin film having a film thickness not allowing light transmission, for example, as an opaque electrode. The above-described metals and alloys thereof can be used for this purpose. As an opaque electrode, for example, metals such as lithium, sodium, potassium, rubidium, cesium, magnesium, calcium, strontium, barium, aluminum, scandium, vanadium, zinc, yttrium, indium, cerium, samarium, europium, terbium, ytterbium, gold, silver, platinum, copper, manganese, titanium, cobalt, nickel, tungsten, and tin, alloys of two or more metals described above, graphite or a graphite intercalation compound, and the like may be used.

The method for preparing the electrode includes a vacuum vapor deposition method, a sputtering method, an ion plating method, a plating method, and the like. Alternatively, a metal electrode can be prepared by a coating method using a metal ink, a metal paste, a low-melting metal, or the like.

In the element structures (a) and (b) described above, an additional layer may be further provided between an anode and an active layer, between an active layer and an anode, and between an active layer and a junction. Examples of the additional layer include charge transport layers such as an electron transport layer and a positive hole transport layer. As the material for the positive hole transport layer and the material for the electron transport layer, the above-described electron-donating compound and electron-accepting compound can be used, respectively. Alternatively, halides and oxides of an alkali metal or an alkaline earth metal such as lithium fluoride as well as fine particles of an inorganic semiconductor such as titanium oxide can be used.

The organic photoelectric conversion element in the present embodiment can generate photovoltaic power between electrodes by irradiating with light such as solar light through transparent or translucent electrodes, and can operate as an organic thin film solar cell. By accumulating a plurality of organic thin film solar cells, the cells can be used as an organic thin film solar cell module. In addition, photocurrent can flow by irradiating with light through transparent or translucent electrodes while applying voltage between the electrodes, and the organic photoelectric conversion element can operate as an organic light sensor. By accumulating a plurality of organic light sensors, the sensors can be used as an organic image sensor.

### Examples

In the following, the present invention will be described in more detail by way of examples, but the present invention is not limited thereto.

In the following examples, the polystyrene-equivalent number average molecular weight and number average molecular weight of polymers were determined by using GPC (PL-GPC2000) manufactured by GPC Laboratory. Polymers were dissolved in o-dichlorobenzene so as to give solutions each having a concentration of about 1% by weight, which were used as measurement samples. As a mobile phase of the GPC, o-dichlorobenzene was used. The above-described measurement samples were run at a flow rate of 1 mL/min at a measurement temperature of 140°C. As a column, three PLGEL 10 µm MIXED-B columns (manufactured by PL Laboratory) connected in series were used.

### Synthesis Example 1

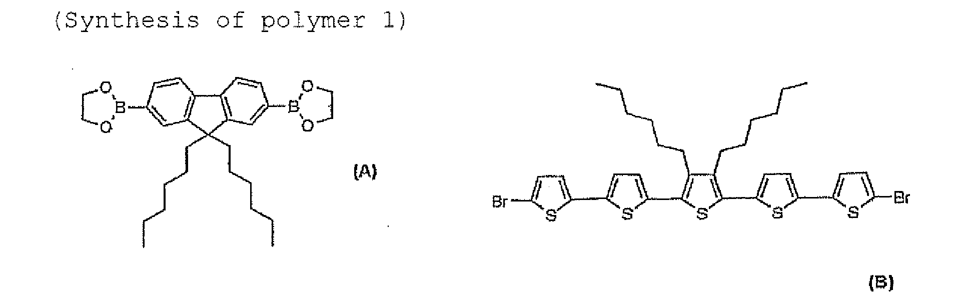

The compound of the above-described formula (A) (7.928 g, 16.72 mmol), the compound of the above-described formula (B) (13.00 g, 17.60 mmol), methyltrioctylammonium chloride (trade name: aliquat 336, manufactured by Aldrich, CH₃N [(CH₂)₇CH₃]₃Cl, density 0.884 g/ml, 25°C, trademark of Henkel Corporation) (4.979 g), and toluene (405 ml) were charged into a 2 L four-necked flask, an atmosphere of which was replaced with argon, and the inside of the flask was degassed by argon-bubbling for 30 minutes with stirring.

Dichlorobis(triphenylphosphine)palladium (II) (0.02 g) was added to the flask, the mixture was heated to 105°C, and 2 mol/L of an aqueous sodium carbonate solution (42.2 ml) was added dropwise to the flask with stirring. After the addition, the mixture was reacted for 5 hours, phenylboronic acid (2. 6 g) and toluene (1.8 ml) were then added to the flask, and the mixture was stirred at 105°C for 16 hours. Toluene (700 ml) and a 7.5% aqueous solution of sodium diethyl dithiocarbamate trihydrate (200 ml) were added to the flask, and the mixture was stirred at 85°C for 3 hours. After the aqueous layer was removed, the reaction mixture was washed twice with 300 ml of ion-exchange water of 60°C, washed once with 300 ml of 3% acetic acid of 60°C, and then washed thrice with 300 ml of ion-exchange water of 60°C. The organic layer was passed through a column filled with Celite, alumina and silica, and the column was washed with hot toluene (800 ml). The resulting solution was concentrated to a volume of 700 ml and poured into 2 L of methanol to obtain a polymer by reprecipitation. The polymer was recovered by filtration, washed in turn with 500 ml of methanol, acetone and methanol, and then vacuum-dried overnight at 50°C to obtain 12.21 g of a pentathienyl-fluorene copolymer (hereinafter referred to as a "polymer 1") having the repeating unit represented by the following formula:

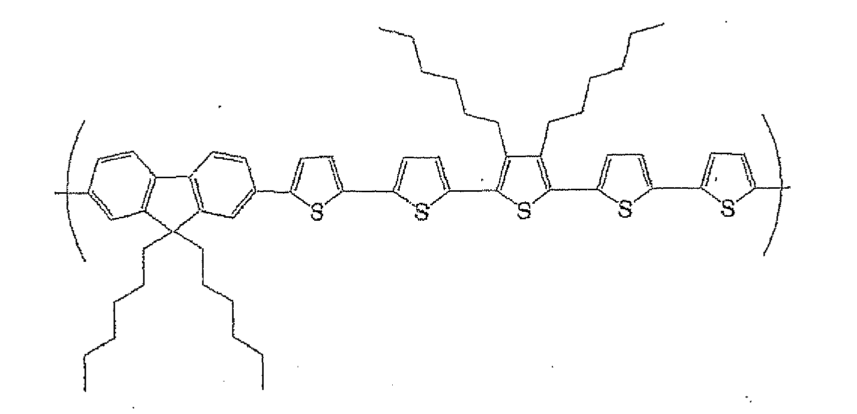

The polystyrene-equivalent number average molecular weight of the polymer 1 was 5.4 × 10⁴ and the weight average molecular weight was 1.1 × 10⁵.

### (Preparation of composition 1)

[6,6] - Phenyl C61-methyl butylate ester (PCBM) (15 parts by weight) (manufactured by Frontier Carbon, E100) as a fullerene derivative, 5 parts by weight of the polymer 1 as an electron-donating compound, and 1,000 parts by weight of o-dichlorobenzene as a solvent were mixed. Then, the mixture was filtrated through a Teflon® filter having a pore size of 1.0 µm to prepare a composition 1.

### <Example 1>

### (Production of organic thin film solar cell)

To a glass substrate having a 150 nm-thick ITO film formed by a sputtering method, which serves as an anode (anode as a solar cell), LiF was vapor-deposited in a thickness of 4 nm by a vacuum vapor deposition machine. Then, the above-described composition 1 was applied by spin coating to obtain an active layer (film thickness about 100 nm) on a front cell of an organic thin film solar cell. Then, an HIL691 solution (manufactured by Plextronics, trade name Plexcore HIL691) was applied by spin coating to obtain a positive hole transport layer (film thickness about 50 nm). The pH of the HIL691 solution was 7 upon measuring using a pH test paper (manufactured by Advantec Toyo, trade name "universal", model number "07011030"). Then, gold was vapor-deposited in a thickness of 2 nm by a vacuum vapor deposition machine, as a charge recombination layer. Then, LiF was vapor-deposited in a thickness of 4 nm by a vacuum vapor deposition machine. Then, the above-described composition 1 was applied by spin coating to obtain an active layer (film thickness about 100 nm) on a back cell of an organic thin film solar cell. Then, an HIL691 solution (manufactured by Plextronics, trade name Plexcore HIL691) was applied by spin coating. Finally, Al was vapor-deposited in a thickness of 100 nm by a vacuum vapor deposition machine, which serves as a cathode (cathode as a solar cell). The degree of vacuum upon the vapor deposition was 1 to 9 × 10⁻³ Pa in all cases. The shape of the resulting organic thin film solar cell was a regular tetragon of 2 mm × 2 mm.

### (Evaluation)

The photoelectric conversion efficiency of the resulting organic thin film solar cell was determined by irradiating with constant light using Solar Simulator (manufactured by Bunkoukeiki Co. Ltd., trade name OTENTO-SUNII: AM1. 5G filter, irradiance 100 mW/cm²), and measuring voltage generated. The open end voltage was 1.4 V.

### <Example 2>

### (Production of organic thin film solar cell)

To a glass substrate having an ITO film of 150 nm thickness formed by a sputtering method, which serves as an anode, a solution prepared by 4-fold diluting a titania sol (manufactured by Catalysts & Chemicals Industries Co., Ltd., PASOL HPW-10R) with water was applied by spin coating, and the substrate was heated at 120°C for 10 minutes in the atmosphere to obtain an electron transport layer (film thickness about 20 nm). Then, the above-described composition 1 was applied by spin coating to obtain an active layer (film thickness about 100 nm) on a front cell of an organic thin film solar cell. Then, an HIL691 solution (manufactured by Plextronics, trade name Plexcore HIL691) was applied by spin coating to obtain a positive hole transport layer (film thickness about 30 nm). The pH of the HIL691 solution was 7 upon measuring using a pH test paper (manufactured by Advantec Toyo, trade name "Universal", model number "07011050"). Then, gold was vapor-deposited in a thickness of 2 nm by a vacuum vapor deposition machine, as a charge recombination layer. Then, a solution prepared by 4-fold diluting a titania sol (manufactured by Catalysts & Chemicals Industries Co., Ltd., PASOL HPW-10R) with water was applied by spin coating to obtain an electron transport layer (film thickness about 20 nm). Heat treatment was not carried out. Then, the above-described composition 1 was applied by spin coating to obtain an active layer (film thickness about 100 nm) on a back cell of an organic thin film solar cell. Then, an HIL691 solution (manufactured by Plextronics, trade name Plexcore HIL691) was applied by spin coating. Finally, Al was vapor-deposited in a thickness of 100 nm by a vacuum vapor deposition machine, which serves as a cathode. The degree of vacuum upon the vapor deposition was 1 to 9 × 10⁻³ Pa in all cases. The shape of the resulting organic thin film solar cell was a regular tetragon of 2 mm × 2 mm.

### (Evaluation)

The photoelectric conversion efficiency of the resulting organic thin film solar cell was determined by irradiating with constant light using Solar Simulator (manufactured by Bunkoukeiki Co., Ltd., trade name OTENTO-SUNII: AM1.5G filter, irradiance 100 mW/cm²), and measuring voltage generated. The open end voltage was 1.5 V.

### <Example 3>

### (Production and evaluation of organic thin film solar cell)

To a glass substrate having a 150 nm-thick ITO film formed by a sputtering method, which serves as an anode, a solution prepared by 4-fold diluting a titania sol (manufactured by Catalysts & Chemicals Industries Co., Ltd. , PASOL HPW-10R) with water was applied by spin coating, and the substrate was heated at 120°C for 10 minutes in the atmosphere to obtain an electron transport layer (film thickness about 20 nm). Then, the above-described composition 1 was applied by spin coating to obtain an active layer (film thickness about 100 nm) on a front cell of an organic thin film solar cell. Then, an OC1200 solution (manufactured by Plextronics, trade name Plexcore OC1200, purchased from Sigma-Aldrich) was applied by spin coating to obtain a positive hole transport layer (film thickness about 50 nm). The pH of the OC1200 solution was 7 upon measuring using a pH test paper (manufactured by Advantec Toyo, trade name "Universal", model number "07011030") . Then, gold was vapor-deposited in a thickness of 2 nm by a vacuum vapor deposition machine, as a charge recombination layer. Then, a solution prepared by 4-fold diluting a titania sol (manufactured by Catalysts & Chemicals Industries Co., Ltd., PASOL HPW-10R) with water was applied by spin coating to obtain an electron transport layer (film thickness about 20 nm). Heat treatment was not carried out. Then, the above-described composition 1 was applied by spin coating to obtain an active layer (film thickness about 100 nm) on a back cell of an organic thin film solar cell. The OC1200 solution (manufactured by Plextronics, trade name Plexcore OC1200, purchased from Sigma-Aldrich) was applied by spin coating. Finally, Al was vapor-deposited in a thickness of 100 nm by a vacuum vapor deposition machine, which serves as a cathode. The degree of vacuum upon the vapor deposition was 1 to 9 × 10⁻³ Pa in all cases. The shape of the resulting organic thin film solar cell was a regular tetragon of 2 mm × 2 mm.

Plexcore OC1200 is a 2% solution of the following sulfonated polythiophene in ethylene glycol monobutyl ether/water (3 : 2).

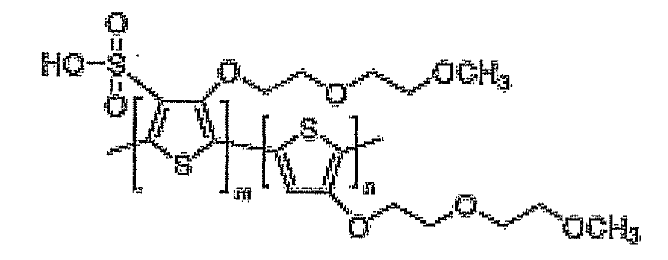

### (Evaluation)

The photoelectric conversion efficiency of the resulting organic thin film solar cell was determined by irradiating with constant light using Solar Simulator (manufactured by Bunkoukeiki Co., Ltd., trade name OTENTO-SUNII: AM1. 5G filter, irradiance 100 mW/cm²), and measuring voltage generated. The open end voltage was 1.5 V.

### <Comparative Example>

### (Production of organic thin film solar cell)

To a glass substrate having a 150 nm-thick ITO film formed by a sputtering method, which serves as a cathode, an HIL691 solution (manufactured by Plextronics, trade name Plexcore HIL691) was applied by spin coating to obtain a positive hole transport layer (film thickness about 50 nm). Then, the above-described composition 1 was applied by spin coating to obtain an active layer (film thickness about 100 nm) of an organic thin film solar cell. Then, LiF was vapor-deposited in a thickness of 4 nm by a vacuum vapor deposition machine. Then, gold was vapor-deposited in a thickness of 2 nm by a vacuum vapor deposition machine, as a charge recombination layer. Then, an HIL691 solution (manufactured by Plextronics, trade name Plexcore HIL691) was applied by spin coating to obtain a positive hole transport layer (film thickness about 50 nm). Then, the above-described composition 1 was applied by spin coating to obtain an active layer (film thickness about 100 nm) of an organic thin film solar cell. Then, LiF was vapor-deposited in a thickness of 4 nm by a vacuum vapor deposition machine, and finally, Al was vapor-deposited in a thickness of 100 nm by a vacuum vapor deposition machine, which serves as an anode. The degree of vacuum upon the vapor deposition was 1 to 9 × 10⁻³ Pa in all cases. The shape of the resulting organic thin film solar cell was a regular tetragon of 2 mm × 2 mm.

### (Evaluation)

The photoelectric conversion efficiency of the resulting organic thin film solar cell was determined by irradiating with constant light using Solar Simulator (manufactured by Bunkoukeiki Co., Ltd., trade name OTENTO-SUNII: AM1.5G filter, irradiance 100 mW/cm²), and measuring voltage generated. The open end voltage was 1.1 V.

### -Evaluation-

As is apparent from the above-described results, it was confirmed that an organic solar cell generating electricity at a high open end voltage can be realized by forming a positive hole transport layer first by coating. Also, it was confirmed that an organic solar cell generating electricity at a higher open end voltage can be realized by using an electron transport layer formed by a coating method using a dispersion liquid having titanium oxide particles dispersed therein.

### Industrial Applicability

According to the present invention, the positive hole transport layer formed by a coating method is first formed among a plurality of layers constituting a junction, and therefore, layers among a plurality of layers constituting a junction except the positive hole transport layer are not damaged during formation of the positive hole transport layer. Accordingly, it is possible to realize an organic photoelectric conversion element having a junction in which the damage upon film formation is suppressed.

## Claims

1. An organic photoelectric conversion element comprising a plurality of active layers and a junction positioned between the active layers which are laminated between a pair of electrodes, wherein
the junctions are formed from a plurality of layers including a positive hole transport layer, and
the positive hole transport layer is formed first by a coating method when the junction is formed.

2. The organic photoelectric conversion element according to claim 1, wherein the positive hole transport layer is formed using a coating solution having a pH of 5 to 9.

3. The photoelectric conversion element according to claim 1 or 2, wherein the junction includes an electron transport layer formed by a coating method using a dispersion liquid prepared by dispersing particles of titanium dioxide in a dispersion medium.

4. The organic photoelectric conversion element according to any one of claims 1 to 3, wherein the active layers contain a conjugated polymer compound and a fullerene derivative.

5. A method for manufacturing an organic photoelectric conversion element by laminating a pair of electrodes and a plurality of active layers and a junction positioned between the active layers, between the pair of electrodes, the method comprising:
forming a positive hole transport layer first by a coating method when the junction formed from a plurality of layers including the positive hole transport layer is formed.
